# EUROPEAN PATENT APPLICATION

(11) **EP 4 609 736 A1**
(43) Date of publication of application: **03.09.2025**
(21) Application number: 23899721.7
(22) Date of filing: 15.11.2023
(51) Int. Cl.: A24F 40/46

(54) **HEATER AND AEROSOL GENERATING APPARATUS**

(30) Priority: 08.12.2022 CN 202211573314
(71) Applicant: Shenzhen First Union Technology Co., Ltd., Shenzhen, Guangdong 518000 (CN)
(72) Inventor: CHEN, Wei, Shenzhen, Guangdong 518000 (CN); HU, Ruilong, Shenzhen, Guangdong 518000 (CN); XU, Zhongli, Shenzhen, Guangdong 518000 (CN); LI, Yonghai, Shenzhen, Guangdong 518000 (CN)
(74) Representative: Ran, Handong
(86) International application number: PCT/CN2023/131708
(87) International publication number: WO 2024/120141

(57) **Abstract**

The present application provides a heater and an aerosol generating apparatus. The heater comprises: a substrate; electric heating film layers, comprising a first electric heating film layer and a second electric heating film layer; and a conductive element, comprising a first electrode and a second electrode. The first electrode and the second electrode feed electric power to the first electric heating film layer and the second electric heating film layer at the same time. The first electrode comprises a third electrode and a fourth electrode that are short-circuited. The second electrode comprises a fifth electrode and a sixth electrode that are short-circuited. The third electrode and the fifth electrode are both in contact with the first electric heating film layer. The fourth electrode and the sixth electrode are both in contact with the second electric heating film layer. In the present application, the electrodes that are short-circuited and partially spaced apart feed the electric power to the first electric heating film layer and the second electric heating film layer at the same time, such that the resistance of the electric heating film layers can be reduced on the whole, the heating rate of an aerosol-forming material is increased, and the use experience of a user is improved.

## Description

### CROSS-REFERENCE TO RELATED APPLICATIONS

The present application claims priority to Chinese Patent Application No. 202211573314.1, entitled "HEATER AND AEROSOL GENERATING APPARATUS" filed with the China National Intellectual Property Administration on December 08, 2022, which is incorporated herein by reference in its entirety.

### TECHNICAL FIELD

The present application relates to the field of electronic atomization technologies, and in particular, to a heater and an aerosol generating apparatus.

### BACKGROUND

During use of smoking products (such as cigarettes or cigars), tobacco is burnt to produce smoke. Attempts have been made to replace these tobacco-burning products by making products that release compounds without burning. An example of the products is a heating and non-burning product that releases a compound by heating rather than burning a tobacco.

Problems of an existing aerosol generating apparatus are that the resistance of an electric heating film layer is relatively high, the heating rate of an aerosol-forming material is relatively slow, and the user experience is poor.

### SUMMARY

The present application provides a heater and an aerosol generating apparatus, and aims to solve the problem that the resistance of an electric heating film layer in the aerosol generating apparatus is relatively high and the heating rate of an aerosol-forming material is relatively slow.

According to an aspect of the present application, a heater is provided, configured to heat an aerosol-forming material in an aerosol generating product, to generate an aerosol; the heater includes:
a substrate;
electric heating film layers, arranged on a surface of the substrate, the electric heating film layers including a first electric heating film layer and a second electric heating film layer; and
a conductive element, including a first electrode and a second electrode, the first electrode and the second electrode supplying electric power to the first electric heating film layer and the second electric heating film layer at the same time,
wherein the first electrode includes a third electrode and a fourth electrode that are short-circuited, and the second electrode includes a fifth electrode and a sixth electrode that are short-circuited; and the third electrode and the fifth electrode are at least partially in contact with the first electric heating film layer to form an electric connection, and the fourth electrode and the sixth electrode are at least partially in contact with the second electric heating film layer to form an electric connection.

According to an aspect of the present application, an aerosol generating apparatus is provided, including:
a housing assembly;
a heater, the heater being arranged in the housing assembly;
a battery cell, configured to supply electric power.

According to the heater and the aerosol generating apparatus provided in the present application, the electrodes that are short-circuited supply electric power to the first electric heating film layer and the second electric heating film layer at the same time, such that the resistance of the electric heating film layers can be reduced as a whole, the heating rate of an aerosol-forming material is increased, and the user experience is improved.

### BRIEF DESCRIPTION OF THE DRAWINGS

One or more embodiments are exemplarily described with reference to the corresponding figures in the accompanying drawings, and the descriptions are not to be construed as limiting the embodiments. Elements in the accompanying drawings that have same reference numerals are represented as similar elements, and unless otherwise particularly stated, the figures in the accompanying drawings are not drawn to scale.
FIG. 1 is a schematic diagram of an aerosol generating apparatus according to an implementation of the present application;
FIG. 2 is a schematic exploded view of an aerosol generating apparatus according to an implementation of the present application;
FIG. 3 is a schematic diagram of a heater according to an implementation of the present application;
FIG. 4 is a schematic expanded diagram of a heater according to an implementation of the present application;
FIG. 5 is a schematic expanded diagram of another heater according to an implementation of the present application; and
FIG. 6 is a schematic expanded diagram of still another heater according to an implementation of the present application.

### DETAILED DESCRIPTION

To facilitate the understanding of the present application, the present application is described in more detail below with reference to accompanying drawings and specific implementations. It needs to be further noted that, when an element is expressed as "being fixed to" another element, the element may be directly on the another element, or one or more intermediate elements may exist between the element and the another element. When one component is expressed as "being connected to" another component, the component may be directly connected to the another component, or one or more intermediate components may exist between the component and the another component. The terms "upper", "lower", "left", "right", "inner", "outer", and similar expressions used in this specification are only used for an illustrative purpose.

Unless otherwise defined, meanings of all technical and scientific terms used in this specification are the same as those usually understood by a person skilled in the technical field to which the present application belongs. Terms used in this specification of the present application herein are merely intended to describe objectives of the specific implementations, but are not intended to limit the present application. A term "and/or" used in this specification includes any or all combinations of one or more related listed items.

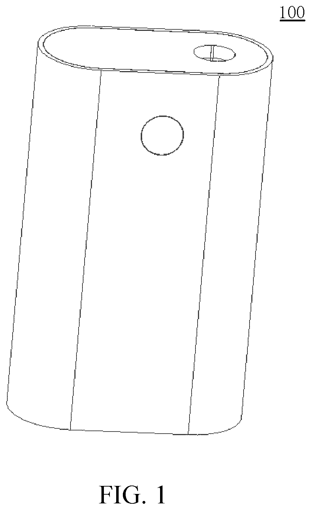

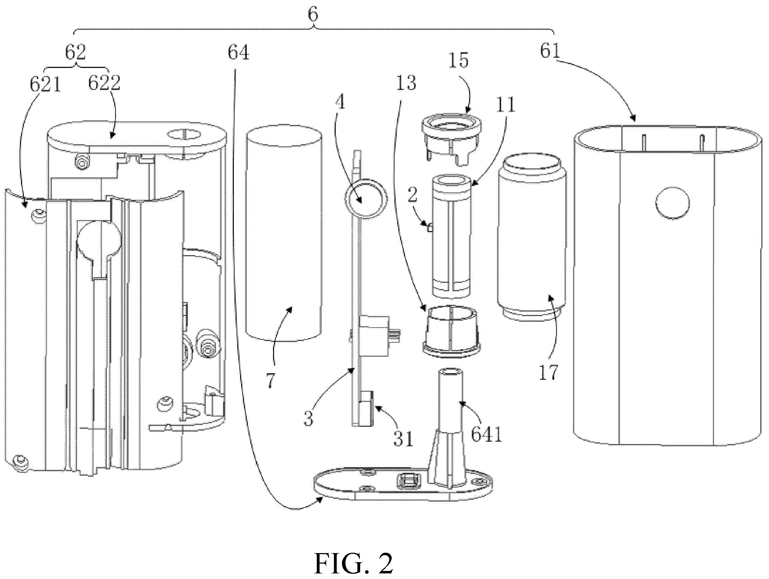

FIG. 1 and FIG. 2 illustrate an aerosol generating apparatus 100 provided in an implementation of the present application. The aerosol generating apparatus 100 includes a housing assembly 6 and a heater 11. The heater 11 is arranged in the housing assembly 6.

The housing assembly 6 includes an outer shell 61, a fixing shell 62, a base, and a bottom cap 64. Both the fixing shell 62 and the base are fixed in the outer shell 61. The base is configured to fix the heater 11. The base is arranged in the fixing shell 62. The bottom cap 64 is arranged at one end of the outer shell 61 and covers the outer shell 61.

The base includes a base 15 disposed on a proximal end of the heater 11 and a base 13 disposed on a distal end of the heater 11. Both the base 15 and the base 13 are arranged in the fixing shell 62. An air intake vent 641 is protrudingly arranged on the bottom cap 64. One end of the base 13 away from the base 15 is connected to the air intake vent 641. The base 15, the heater 11, the base 13, and the air intake vent 641 are coaxially arranged. In addition, the heater 11 and the base 15 as well as the base 13 are sealed by seals, the base 13 and the air intake vent 641 are also sealed, and the air intake vent 641 is in communication with outside air to facilitate smooth air inletting during vaping by a user.

The aerosol generating apparatus 100 further includes a circuit 3 and a battery cell 7. The fixing shell 62 includes a front shell 621 and a rear shell 622. The front shell 621 is fixedly connected to the rear shell 622. The circuit 3 and the battery cell 7 are both arranged in the fixing shell 62. The battery cell 7 is electrically connected to the circuit 3. A button 4 is protrudingly arranged on the outer shell 61. Electric heating film layers on the heater 11 can be energized or unenergized by pressing the button 4. The electric heating film layers include an electric heating coating. Preferably, an infrared electric heating coating capable of radiating infrared rays is used. The circuit 3 is further connected to a charging interface 31, the charging interface 31 is exposed on the bottom cap 64, and the user may charge or upgrade the aerosol generating apparatus 100 through the charging interface 31, to ensure continuous use of the aerosol generating apparatus 100.

The aerosol generating apparatus 100 further includes a heat insulation pipe 17, the heat insulation pipe 17 is arranged in the fixing shell 62, the heat insulation pipe 17 is sleeved on the periphery of the heater 11, and the heat insulation pipe 17 can prevent a lot of heat from being transferred to the outer shell 61 and causing the user to feel hot in the hand. The heat insulation pipe includes a heat insulation material. The heat insulation material can be heat insulation glue, aerogel, an aerogel blanket, asbestos, aluminum silicate, calcium silicate, diatomite, zirconia, and the like. The heat insulation pipe 17 can alternatively be a vacuum heat insulation pipe. An infrared ray reflective coating may be further formed in the heat insulation pipe 17, to reflect part of the heat radiated by the heater 11 back to the heater 11, to further improve the heating efficiency.

The aerosol generating apparatus 100 further includes a temperature sensor 2, for example, an NTC thermistor, a PTC thermistor, or a thermoelement, configured to measure a real-time temperature of the heater 11 and transmit the measured real-time temperature to the circuit 3. The circuit 3 adjusts a magnitude of a current flowing through the heater 11 based on the real-time temperature.

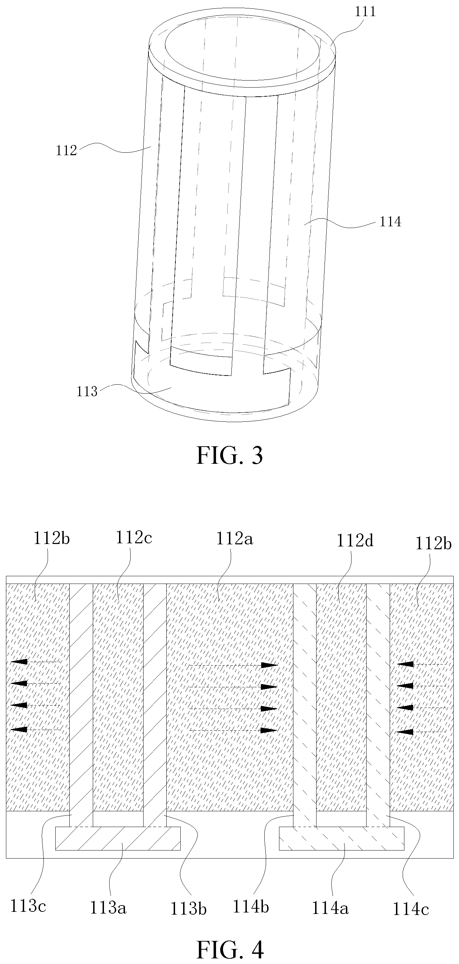

FIG. 3 and FIG. 4 illustrate a heater provided in a first example of the present application. As shown in FIG. 3 and FIG. 4, the heater 11 includes:
a substrate 111, in which a chamber suitable for accommodating an aerosol-forming material is formed.

Specifically, the substrate 111 includes a proximal end, a distal end, and a surface extending between the proximal end and the distal end. Inside of the substrate 111 is hollow to form the chamber. The substrate 111 may be in a tubular shape, for example, a cylinder, a prism, or another columnar shape. The substrate 111 is preferably in the shape of the cylinder, and the chamber is a cylindrical hole that penetrates through a middle part of the substrate 111.

In an example, the inner diameter of the substrate 111 ranges from 6 mm to 15 mm, or ranges from 7 mm to 15 mm, or ranges from 7 mm and 14 mm, or ranges from 7 mm to 12 mm, or ranges from 7 mm to 10 mm. The axial extension length of the substrate 111 ranges from 15 mm to 30 mm, or ranges from 15 mm to 28 mm, or ranges from 15 mm to 25 mm, or ranges from 16 mm to 25 mm, or ranges from 18 mm to 25 mm, or ranges from 18 mm to 24 mm, or ranges from 18 mm to 22 mm. The substrate 111 of the size is suitable for a thick and short aerosol generating product.

In an example, the inner diameter of the substrate 111 ranges from 5 mm to 5.9 mm, and may be 5.5 mm, 5.4 mm, or the like in a specific example. The axial extension length of the substrate 111 ranges from 30 mm to 60 mm, or ranges from 30 mm to 55 mm, or ranges from 30 mm to 50 mm, or ranges from 30 mm to 45 mm, or ranges from 30 mm to 40 mm. The substrate 111 of the size is suitable for a long and thin aerosol generating product.

The substrate 111 may be made of a material that is high-temperature resistant and can transmit infrared rays, such as quartz glass, ceramic, or mica, or may be made of another material having high infrared-ray transmittance, for example, a high-temperature-resistant material having an infrared-ray transmittance of at least 95%. The material of the substrate is not specifically limited herein.

The aerosol-forming material is a material that can release a volatile compound that can form an aerosol. The volatile compound may be released by heating the aerosol-forming material. The aerosol-forming material may be solid, or liquid, or components including solid and liquid. The aerosol-forming material may be loaded onto a carrier or a support through adsorption, coating, or impregnation, or in another manner. The aerosol-forming material may conveniently be a part of an aerosol generating product.

The aerosol-forming material may include nicotine. The aerosol-forming material may include tobaccos, for example, may include a tobacco-containing material including volatile compounds with a tobacco aroma. The volatile compounds with a tobacco aroma are released from the aerosol-forming material when the aerosol-forming material is heated. The aerosol-forming material may include at least one aerosol-forming agent. The aerosol-forming agent may be any suitable known compound or a mixture of compounds. During use, the compound or the mixture of compounds facilitates dense and stable aerosol formation, and is substantially resistant to thermal degradation at an operating temperature of an aerosol generating system. Suitable aerosol-forming agents are well known in the related art, including but not limited to: polyol, such as triethylene glycol, 1,3-butanediol, and glycerol; ester of polyol such as glyceryl monoacetate, glyceryl diacetate, or glyceryl triacetate; and fatty acid ester of monobasic carboxylic acid, dibasic carboxylic acid, or polybasic carboxylic acid such as dimethyl dodecane dibasic ester and dimethyl tetradecane dibasic ester.

An infrared electric heating coating 112 generates heat under electric power, to generate infrared rays having specific wavelengths, for example: far infrared rays ranging from 8 µm to 15 µm transmit through the substrate 111, and then heat the aerosol-forming material in the chamber. When the wavelengths of the infrared rays match absorption wavelengths of the aerosol-forming material, energy of the infrared rays is easily absorbed by the aerosol-forming material.

The infrared electric heating coating 112 is preferably formed by fully and uniformly mixing far infrared electric heating ink, ceramic powder, and an inorganic adhesive, and is then coated on the outer surface of the substrate 111. After being dried and cured for a specified period of time, the infrared electric heating coating 112 has a thickness of 30 µm to 50 µm. Certainly, the infrared electric heating coating 112 may further be formed by mixing and stirring stannic chloride, tin oxide, antimony butter, titanium tetrachloride, and anhydrous cupric sulfate according to a specific ratio, and is then coated on the outer surface of the substrate 111. Alternatively, the infrared electric heating coating 112 may be one of a silicon carbide ceramic layer, a carbon fiber composite layer, a zirconium-titanium oxide ceramic layer, a zirconium-titanium nitride ceramic layer, a zirconium-titanium boride ceramic layer, a zirconium-titanium carbide ceramic layer, a ferric oxide ceramic layer, a ferric nitride ceramic layer, a ferric boride ceramic layer, a ferric carbide ceramic layer, a rare-earth oxide ceramic layer, a rare-earth nitride ceramic layer, a rare-earth boride ceramic layer, a rare-earth carbide ceramic layer, a nickel-cobalt oxide ceramic layer, a nickel-cobalt nitride ceramic layer, a nickel-cobalt boride ceramic layer, a nickel-cobalt carbide ceramic layer, or a high silica molecular sieve ceramic layer. The infrared electric heating coating 112 may alternatively be an existing coating made of another material.

The infrared electric heating coating 112 may be formed on the surface of the substrate 111. The infrared electric heating coating 112 may be formed on the outer surface of the substrate 111, or may be formed on the inner surface of the substrate 111.

In a preferable implementation, the infrared electric heating coating 112 is formed on the outer surface of the substrate 111. The infrared electric heating coating 112 is spaced apart from the proximal end or the distal end of the substrate 111, namely, the axial extension length of the infrared electric heating coating 112 is less than the axial extension length of the substrate 111. In other examples, the infrared electric heating coating 112 is not spaced apart from the proximal end or the distal end of the substrate 111, namely, it is also feasible that the axial extension length of the infrared electric heating coating 112 is equal to the axial extension length of the substrate 111. In an example, the spacing distance between the infrared electric heating coating 112 and the proximal end of the substrate 111 ranges from 0 mm to 1 mm, and the spacing distance between the infrared electric heating coating 112 and the distal end of the substrate 111 ranges from 2.5 mm to 4 mm. That is, the spacing distance between the infrared electric heating coating 112 and the proximal end of the substrate 111 is less than the spacing distance between the infrared electric heating coating 112 and the distal end of the substrate 111.

Along the peripheral direction of the substrate 111, the infrared electric heating coating 112 includes an infrared electric heating coating 112a, an infrared electric heating coating 112b, an infrared electric heating coating 112c, and an infrared electric heating coating 112d.

The conductive element includes electrodes 113 and electrodes 114 which are spaced apart on the substrate 111 and are configured to feed electric power supplied by the battery cell 7 to the infrared electric heating coating 112.

The electrodes 113 and the electrodes 114 are both conductive coatings. The conductive coatings may be metal coatings. The metal coatings may include silver, gold, palladium, platinum, copper, nickel, molybdenum, tungsten, niobium, or an alloy material of the above metals.

The electrodes 113 are approximately U-shaped, including an electrode 113a extending along the peripheral direction of the substrate 111 and having an arc shape, and an electrode 113b and an electrode 113c extending along the axial direction of the substrate 111 and having a strip shape.

The electrode 113a is arranged between the distal end of the substrate 111 and the infrared electric heating coating 112. The electrode 113a is spaced apart from the distal end of the substrate 111 and the infrared electric heating coating 112. The spacing distance between the electrode 113a and the infrared electric heating coating 112 is slightly greater than the spacing distance between the electrode 113a and the distal end of the substrate 111. In a specific example, the spacing distance between the electrode 113a and the infrared electric heating coating 112 is approximately 1 mm, and the spacing distance between the electrode 113a and the distal end of the substrate 111 is approximately 0.5 mm.

The electrode 113b and the electrode 113c are spaced apart from each other along the peripheral direction of the substrate 111. The electrode 113b and the electrode 113c are approximately parallel. Certainly, it is also feasible that the electrode 113b is not parallel to the electrode 113c. The electrode 113b is shorted to the electrode 113c via the electrode 113a. Specifically,
one end of the electrode 113b is connected to the electrode 113a, and the other end of the electrode 113b is disposed close to the proximal end of the substrate 111 after extending along the axial direction of the substrate 111. The axial extension length of the electrode 113b is greater than the axial extension length of the infrared electric heating coating 112a. Part of the electrode 113b keeps in contact with the infrared electric heating coating 112a to form an electric connection, and the part of the electrode 113b further keeps in contact with the infrared electric heating coating 112c.

One end of the electrode 113c is connected to the electrode 113a, and the other end of the electrode 113c is disposed close to the proximal end of the substrate 111 after extending along the axial direction of the substrate 111. The axial extension length of the electrode 113c is greater than the axial extension length of the infrared electric heating coating 112b. Part of the electrode 113c keeps in contact with the infrared electric heating coating 112b to form an electric connection, and the part of the electrode 113c further keeps in contact with the infrared electric heating coating 112c.

The electrodes 114 are approximately U-shaped, including an electrode 114a extending along the peripheral direction of the substrate 111 and having an arc shape, and an electrode 114b and an electrode 114c extending along the axial direction of the substrate 111 and having a strip shape.

The structural design of the electrode 114a is similar to the structural design of the electrode 113a, the structural design of the electrode 114b is similar to the structural design of the electrode 113b, and the structural design of the electrode 114c is similar to the structural design of the electrode 113c. The difference lies in that part of the electrode 114b keeps in contact with the infrared electric heating coating 112a to form an electric connection, and the part of the electrode 114b further keeps in contact with the infrared electric heating coating 112d. Part of the electrode 114c keeps in contact with the infrared electric heating coating 112b to form an electric connection, and the part of the electrode 114c further keeps in contact with the infrared electric heating coating 112d.

After the electrode 113 and the electrode 114 are energized, the electrode 113 and the electrode 114 feed the electric power supplied by the battery cell 7 to the infrared electric heating coating 112a and the infrared electric heating coating 112b. That is, the infrared electric heating coating 112a and the infrared electric heating coating 112b are equivalent to being connected in parallel between the electrode 113 and the electrode 114. By means of the infrared electric heating coatings connected in parallel, the resistance of the infrared electric heating coating 112 can be lowered as a whole.

Assuming that a current flows in from the electrode 113 and flows out through the electrode 114, the flow direction of the current on the infrared electric heating coating 112a and the infrared electric heating coating 112b extends substantially along the peripheral direction of the substrate 111 (as shown by dashed arrows in the figure). If the current on the infrared electric heating coating 112a flows substantially clockwise along the peripheral direction of the substrate 111, the current on the infrared electric heating coating 112b flows substantially counterclockwise along the peripheral direction of the substrate 111.

The infrared electric heating coating 112c is electrically connected between the electrode 113b and the electrode 113c, and the infrared electric heating coating 112d is electrically connected between the electrode 114b and the electrode 114c. Due to the fact that the electrode 113b is short-circuited to the electrode 113c via the electrode 113a, and the electrode 114b is short-circuited to the electrode 114c via the electrode 114a, no currents flow through the infrared electric heating coating 112c and the infrared electric heating coating 112d, that is, the infrared electric heating coating 112c and the infrared electric heating coating 112d do not actively generate heat during power-up.

In this way, in an initial heating process, due to the fact that the infrared electric heating coating 112a and the infrared electric heating coating 112b are powered to generate heat, and the infrared electric heating coating 112c and the infrared electric heating coating 112d do not actively generate heat during power-up, an uneven temperature field of staggered high-and low-temperature is formed along the peripheral direction of the substrate 111. Such the temperature field facilitates volatilization of different components of the aerosol-forming material, and forms an aerosol having enriched tastes.

With an increase of a period of time of heating, due to an effect of heat conduction, the temperature of the infrared electric heating coating 112c and the infrared electric heating coating 112d may increase, so that infrared rays may be radiated to heat the aerosol-forming material in a corresponding region. In this way, the vaping consistency may be further maintained, to ensure that a user can still vape a sufficient aerosol having enriched tastes in a later period.

It needs to be further noted that, in the example of FIG. 3 to FIG. 4, it is also feasible that the infrared electric heating coating 112c does not keep in contact with the electrode 113b and the electrode 113c and is arranged only between the electrode 113b and the electrode 113c. It is also feasible that the infrared electric heating coating 112d does not keep in contact with the electrode 114b and the electrode 114c and is arranged only between the electrode 114b and the electrode 114c.

It needs to be further noted that, the resistance of the infrared electric heating coating 112a or the infrared electric heating coating 112b may be adjusted according to needs. According to a general calculation formula R = ρL/S of a resistance, when a specific resistance ρ (when the infrared electric heating coating is uniformly applied, the specific resistance ρ thereof is specific) is given, a value of the resistance depends on L and S. Therefore, by setting two parameters L and S of the infrared electric heating coating, the value of the resistance of each infrared electric heating coating can be adjusted. For example, by reducing the peripheral distance between the electrode 113b and the electrode 114b or reducing the peripheral distance between the electrode 113c and the electrode 114c, the resistance of the infrared electric heating coating 112a or the infrared electric heating coating 112b can be reduced. Accordingly, by increasing the peripheral distance between the infrared electric heating coating 112c and the infrared electric heating coating 112d, the corresponding resistance increases. By adjusting an equivalent value of resistance of each infrared electric heating coating, the power distribution of each region can be adjusted, to adjust the temperature distribution of each region.

It may be understood that, the values of resistance of the infrared electric heating coating 112a and the infrared electric heating coating 112b that are connected in parallel may be equal or may be different (for example, the axial extension lengths of the infrared electric heating coating 112a and the infrared electric heating coating 112b are equal, and the peripheral extension lengths of the infrared electric heating coating 112a and the infrared electric heating coating 112b are different). Alternatively, the electrode 113b has a first peripheral distance with the electrode 114b along the counterclockwise direction of the substrate 111, the electrode 113c has a second peripheral distance with the electrode 114c along the clockwise direction of the substrate 111, and the first peripheral distance is different from the second peripheral distance. The heating power is similar thereto. Quantities of the infrared electric heating coatings 112a and the infrared electric heating coatings 112b are likewise not limited, and there may be a plurality of infrared electric heating coatings 112a and 112b.

In an example, if an equivalent value of resistance of the infrared electric heating coating 112a relative to that of the infrared electric heating coating 112b is relatively small, the heating power of the infrared electric heating coating 112a is relatively large, and the heating speed of the infrared electric heating coating 112a is relatively fast. In this way, the temperature of part of the aerosol-forming material corresponding to the infrared electric heating coating 112a, relative to part of the aerosol-forming material corresponding to the infrared electric heating coating 112b, may increase rapidly and generate a vapable aerosol, to further shorten a period of time for preheat of the aerosol-forming material and reduce a waiting time for vaping.

It needs to be further noted that, relative to the heating speed of the infrared electric heating coating 112b, the heating speed of the infrared electric heating coating 112a being faster may be verified in the following manner: a same preset temperature is set, and when the heating temperature of the infrared electric heating coating 112a reaches the preset temperature from an initial temperature (for example, an ambient temperature) and the heating temperature of the infrared electric heating coating 112b is less than the preset temperature, the heating speed of the infrared electric heating coating 112a is faster than the heating speed of the infrared electric heating coating 112b. The preset temperature may be a maximum temperature of the aerosol generating apparatus 100, or may be an operating temperature, that is, a temperature at which the aerosol-forming material can generate an aerosol.

It needs to be further noted that, in the example in FIG. 3 and FIG. 4, the electrode 113a and the electrode 114a are both disposed close to the distal end of the substrate 111, which facilitates wiring with the battery cell 7. For example, a first lead electrically connected to the electrode 113, and a second lead electrically connected to the electrode 114. One ends of the first lead and the second lead may be disposed at the distal end of the substrate 111, and the other ends of the first lead and the second lead are electrically connected to the battery cell 7.

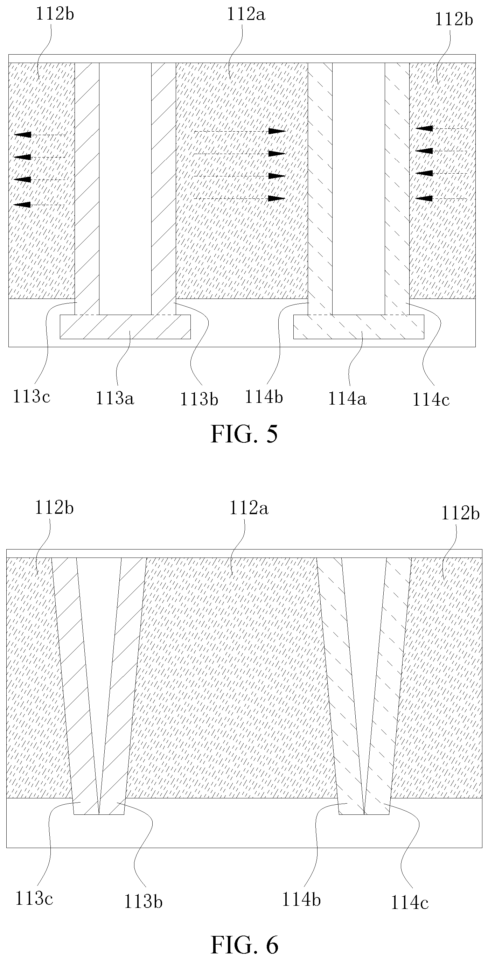

FIG. 5 illustrates a heater according to a second example of the present application.

Different from the example in FIG. 3 to FIG. 4, no infrared electric heating coatings 112c are arranged between the electrode 113b and the electrode 113c, and no infrared electric heating coatings 112d are arranged between the electrode 114b and the electrode 114c.

It needs to be further noted that, in an alternative example, it is also feasible that the electrode 113a is arranged between the electrode 113b and the electrode 113c, and the electrode 114a is arranged between the electrode 114b and the electrode 114c, so that the electrode 113 and the electrode 114 present an H shape.

FIG. 6 illustrates a heater according to a third example of the present application.

Different from the example in FIG. 3 to FIG. 4, no electrodes 113a are provided for the electrode 113, and no electrodes 114a are provided for the electrode 114. The electrode 113 and the electrode 114 present a V shape. Specifically, one end of the electrode 113b is connected to one end of the electrode 113c, so that a short circuit is formed between the electrode 113b and the electrode 113c. The other end of the electrode 113b and the other end of the electrode 113c extend along the axial direction of the substrate 111 and are spaced apart from each other. A short-circuited connection between the electrode 113b and the electrode 113c is arranged between the distal end of the substrate 111 and the infrared electric heating coating 112. The structure of the electrode 114b is designed similar to that of the electrode 114c.

It needs to be further noted that, the structure design of the electrode 113 and the electrode 114 may be different. For example, it is also feasible that the electrode 113 presents a U shape and the electrode 114 presents a V shape.

It needs to be further noted that, the specification of the present application and the drawings thereof provide preferred embodiments of the present application. However, the present application may be implemented in various different forms, and is not limited to the embodiments described in this specification. These embodiments are not used as an additional limitation on the content of the present application, and are described for providing a more thorough and comprehensive understanding of the content disclosed in the present application. Moreover, various embodiments not listed above formed by further combining the foregoing technical features with each other are all construed as falling within the scope of the present application. Further, for a person of ordinary skill in the art, improvements or modifications may be made according to the above descriptions, and all these improvements and modifications shall fall within the protection scope of the appended claims of the present application.

## Claims

1. A heater, configured to heat an aerosol-forming material in an aerosol generating product to generate an aerosol, wherein the heater comprises:
a substrate;
electric heating film layer, arranged on a surface of the substrate, the electric heating film layer comprising a first electric heating film layer and a second electric heating film layer; and
a conductive element, comprising a first electrode and a second electrode, the first electrode and the second electrode supplying electric power to the first electric heating film layer and the second electric heating film layer at the same time,
wherein the first electrode comprises a third electrode and a fourth electrode that are short-circuited, and the second electrode comprises a fifth electrode and a sixth electrode that are short-circuited; and the third electrode and the fifth electrode are at least partially in contact with the first electric heating film layer to form an electric connection, and the fourth electrode and the sixth electrode are at least partially in contact with the second electric heating film layer to form an electric connection.

2. The heater according to claim 1, wherein the third electrode, the fourth electrode, the fifth electrode, and the sixth electrode all extend along the axial direction of the substrate; and
the first electric heating film layer and the second electric heating film layer are spaced apart from each other along the peripheral direction of the substrate, and current on the first electric heating film layer and the second electric heating film layer flows substantially along the peripheral direction of the substrate.

3. The heater according to claim 1, wherein
one end of the third electrode and one end of the fourth electrode are connected to each other, and the other end of the third electrode and the other end of the fourth electrode are spaced apart from each other; and/or
one end of the fifth electrode and one end of the sixth electrode are connected to each other, and the other end of the fifth electrode and the other end of the sixth electrode are spaced apart from each other.

4. The heater according to claim 3, wherein the substrate comprises a proximal end and a distal end; and a connection between the third electrode and the fourth electrode is between the electric heating film layer and the distal end of the substrate, and a connection between the fifth electrode and the sixth electrode is between the electric heating film layer and the distal end of the substrate.

5. The heater according to claim 3, wherein the first electrode and the second electrode present a V shape.

6. The heater according to claim 1, wherein
the third electrode and the fourth electrode are spaced apart from each other, the first electrode comprises a seventh electrode, one end of the seventh electrode is connected to the third electrode, and the other end of the seventh electrode is connected to the fourth electrode; and/or
the fifth electrode and the sixth electrode are spaced apart from each other, the second electrode comprises an eighth electrode extending along the peripheral direction of the substrate, one end of the eighth electrode is connected to the fifth electrode, and the other end of the eighth electrode is connected to the sixth electrode.

7. The heater according to claim 6, wherein the substrate comprises a proximal end and a distal end, and the seventh electrode and the eighth electrode are arranged between the electric heating film layer and the distal end of the substrate.

8. The heater according to claim 6, wherein the first electrode and the second electrode present a U shape or an H shape.

9. The heater according to claim 1, wherein no electric heating film layers are arranged between the third electrode and the fourth electrode, and no electric heating film layers are arranged between the fifth electrode and the sixth electrode; or
the electric heating film layer further comprises a third electric heating film layer and a fourth electric heating film layer, the third electric heating film layer is arranged between the third electrode and the fourth electrode, and the fourth electric heating film layer is arranged between the fifth electrode and the sixth electrode.

10. The heater according to claim 1, wherein the substrate is configured in a tubular structure; and
the inner diameter of the substrate ranges from 6 mm to 15 mm and the axial extension length of the substrate ranges from 15 mm to 30 mm.

11. The heater according to claim 1, wherein the electric heating film layer comprises an infrared electric heating coating configured to receive electric power to generate heat and thereby produce infrared radiation.

12. The heater according to claim 1, wherein the axial extension length of the electric heating film layer is less than or equal to the axial extension length of the substrate.

13. The heater according to claim 1, wherein the substrate comprises a proximal end and a distal end; and
the electric heating film layer is spaced apart from the proximal end and the distal end of the substrate, and the spacing distance between the electric heating film layer and the proximal end of the substrate is less than the spacing distance between the electric heating film layer and the distal end of the substrate.

14. The heater according to claim 1, wherein the axial extension length of the first electric heating film layer is equal to the axial extension length of the second electric heating film layer, and the peripheral extension length of the first electric heating film layer is different from the peripheral extension length of the second electric heating film layer; or
the resistance of the first electric heating film layer is different from the resistance of the second electric heating film layer; or
the heating power of the first electric heating film layer is different from the heating power of the second electric heating film layer; or
the third electrode has a first peripheral distance from the fifth electrode along a first peripheral direction of the substrate, the fourth electrode has a second peripheral distance from the sixth electrode along a second peripheral direction of the substrate, and the first peripheral distance is different from the second peripheral distance.

15. An aerosol generating apparatus, comprising:
a housing assembly;
the heater according to any one of claims 1 to 14, wherein the heater is arranged in the housing assembly; and
a battery cell, configured to supply electric power.
